Europäisches Patentamt

European Patent Office

Office européen des brevets

(11) Publication number: **0 471 272 A1**

# EUROPEAN PATENT APPLICATION

(21) Application number: **91113195.1**

(22) Date of filing: **06.08.91**

(51) Int. Cl.⁵: **H05K 13/08**, H05K 13/04

(30) Priority: **11.08.90 JP 212945/90**

(43) Date of publication of application:
**19.02.92 Bulletin 92/08**

(84) Designated Contracting States:
**DE FR GB NL**

(71) Applicant: **TDK Corporation**
**13-1, Nihonbashi 1-chome Chuo-Ku**
**Tokyo-to(JP)**

(72) Inventor: **Harigane, Kotaro**
**76-12, Kitsunemori, Kisakatamachi**
**Yuri-gun, Akita-ken(JP)**
Inventor: **Takahashi, Kenichi**
**7-1, Kotaki Aza Shimoyama, Kisakatamachi**
**Yuri-gun, Akita-ken(JP)**

(74) Representative: **Eisenführ, Speiser & Strasse**
**Martinistrasse 24**
**W-2800 Bremen 1(DE)**

(54) Electronic element mounting method and apparatus therefor.

(57) A circuit element mounting method and an apparatus therefor capable of effectively preventing the positional and rotational deviation of a circuit element (62) with respect to a suction nozzle (44), to thereby ensure the circuit element mounting operation with high accuracy. The position and posture of the circuit element (62) held on the suction nozzle (44) moved to a circuit element mounting position (R) in an X-Y plane are recognized through an image processing unit including an image pickup means (50) and then the suction nozzle (44) is kept stationary.

FIG. 1

## BACKGROUND OF THE INVENTION

This invention relates to a circuit element mounting method and an apparatus therefor, and more particularly to a method for mounting circuit elements such as various kinds of chip-type circuit elements, surface-mounting type integrated circuit elements and the like on a printed circuit board and an apparatus therefor.

A typical circuit element mounting apparatus which has been conventionally proposed in the art is disclosed in, for example, Japanese Patent Application Laid-Open Publication No. 62-21469 (21469/1987). The disclosed circuit element mounting apparatus is so constructed that leads of a circuit element held on a suction nozzle by suction are recognized by means of an image processing unit including an image pickup means, resulting in the position and posture (rotation) of the leads being corrected, and then the circuit element is mounted on a printed circuit board while being suckedly held on the suction nozzle.

In the conventional circuit element mounting apparatus as disclosed in Japanese Patent Application Laid-Open Publication No. 62-21469, the image pickup means is arranged independently of the suction nozzle. More particularly, the image pickup means is arranged at a position irrelevant to a mounting position in an X-Y coordinate plane on which the suction nozzle is to be moved for mounting the circuit element on the printed circuit board. Thus, in the conventional apparatus, it is required to move the suction nozzle to a location above the printed circuit board which is kept stopped for positioning and vertically move it with respect to the printed circuit board for the circuit element mounting operation, after the position and posture of the circuit element are recognized through the image pickup means.

Unfortunately, the movement of the suction nozzle in the X-Y directions while suckedly holding the circuit element on the suction nozzle after the operation of recognizing the position and posture of the circuit element by means of the image processing unit including the image pickup means causes misregistration or deviation between the suction nozzle and the circuit element, so that the mounting of the circuit element on the printed circuit board is carried out in an incorrect posture or failed. More particularly, when the mounting of a large-sized circuit element such as a surface-mounting type integrated circuit (IC) element or the like is to be carried out, the above-described misregistration or deviation causes the suction nozzle to fail to hold the circuit element while keeping it in a correct position or posture, resulting in the circuit element being mounted in an incorrect posture on the printed circuit board. Whereas, when a circuit element in which leads are arranged at small intervals such as a QFP or the like is to be mounted on the printed circuit board, the misregistration causes the mounting to be substantially failed even when the misregistration is slight.

## SUMMARY OF THE INVENTION

The present invention has been made in view of the foregoing disadvantage of the prior art.

Accordingly, it is an object of the present invention to provide a circuit element mounting method which is capable of carrying out the mounting operation with high accuracy.

It is another object of the present invention to provide a circuit element mounting method which is capable of accomplishing the mounting operation while keeping a circuit element in a correct posture.

It is a further object of the present invention to provide a circuit element mounting method which is capable of minimizing the amount of operation of a suction nozzle carried out after the position and posture of a circuit element is recognized through an image processing unit including an image pickup means.

It is still another object of the present invention to provide a circuit element mounting apparatus which is capable of permitting the mounting operation to be carried out with high accuracy.

It is yet another object of the present invention to provide a circuit element mounting apparatus which is capable of attaining the mounting operation while keeping a circuit element in a correct posture.

It is a still further object of the present invention to provide a circuit element mounting apparatus which is capable of substantially eliminating the deviation of a circuit element with respect to a suction nozzle.

It is a yet further object of the present invention to provide a circuit element mounting apparatus which is capable of minimizing the amount of operation of a suction nozzle carried out after the position and posture of a circuit element is recognized through an image processing unit including an image pickup means.

In accordance with one aspect of the present invention, a circuit element mounting method is provided which is adapted to hold each of circuit elements fed from a circuit element feed section on a suction nozzle by suction to mount it on a position designated on a printed circuit board supported on an X-Y table. The method comprises the steps of moving the suction nozzle to a location above a circuit element mounting position in an X-Y plane while holding the circuit element on the suction nozzle by suction, recognizing the position and posture of the circuit element held on the suction nozzle by means of an image processing unit including an image pickup means, and moving the X-Y table depending upon results of the above-described recognizing step to carry out mounting of the circuit element on the designated position on the printed circuit board.

In accordance with another aspect of the present invention, a circuit element mounting apparatus for holding each of circuit elements fed from a circuit element feed section on a suction nozzle by suction to mount it on a position designated on a printed circuit board supported on an X-Y table is provided. The apparatus includes an image pickup means arranged at a position which permits an image of the circuit element held on the suction nozzle moved to a location above a circuit element mounting position in an X-Y plane to be taken to recognize the position and posture of the circuit element. The X-Y table has a range of movement sufficient to permit an operation of moving the printed circuit board so as to prevent it from obstructing image pickup of the circuit element through the image pickup means and an operation of coinciding a coordinate of the designated position on the printed circuit board in the X-Y plane with the circuit element mounting position to be carried out.

In a preferred embodiment of the present invention, the image pickup means is movable within a predetermined range.

In a preferred embodiment of the present invention, the suction nozzle is arranged so as to merely rotate for correction and vertically move after the circuit element is recognized through the image pickup means.

In a preferred embodiment of the present invention, the X-Y table is arranged so as to exhibit a function of rotating for correction, so that the suction nozzle merely vertically moves after the circuit element is recognized through the image pickup means.

In a preferred embodiment of the present invention, the X-Y table is arranged so as to exhibit both a function of vertically moving and a function of rotating for correction, so that the suction nozzle is kept stationary after the circuit element is recognized through the image pickup means.

In a preferred embodiment of the present invention, the image pickup means is mounted on the X-Y table. In this instance, the range of movement of the X-Y table is defined so as to permit the image pickup means to be positioned in proximity to the circuit element mounting position.

In the present invention constructed as described above, the position and posture of the circuit element held on the suction nozzle moved to the coordinate position for mounting in the X-Y plane are recognized by means of the image processing including the image pickup means. Thereafter, the suction nozzle is not moved within the X-Y plane. Substitutionally, the printed circuit board is moved through the operation of the X-Y table. Thus, the deviation of position and posture of the circuit element due to the movement of the suction nozzle is effectively eliminated, to thereby ensure the circuit element mounting operation with high accuracy.

BRIEF DESCRIPTION OF THE DRAWINGS

These and other objects and many of the attendant advantages of the present invention will be readily appreciated as the same becomes better understood by reference to the following detailed description when considered in connection with the accompanying drawings; wherein:

Fig. 1 is an enlarged plan view showing an embodiment of a circuit element mounting apparatus according to the present invention;

Fig. 2 is a front elevation view of the apparatus shown in Fig. 1;

Fig. 3 is a side elevation view of the apparatus shown in Fig. 1;

Fig. 4 is a schematic view showing the manner of mounting a chip-type circuit element on a printed circuit board;

Fig. 5 is a schematic view exemplifying the manner of correcting the position and posture of a chip-type circuit element;

Fig. 6 is a schematic view showing the manner of picking up a surface-mounting type integrated circuit element by means of a suction nozzle and recognizing the position and posture of the circuit element by means of an image processing apparatus including an image pickup means;

Fig. 7 is a schematic view exemplifying the manner of correcting the position and posture of a surface-mounting type integrated circuit element;

Fig. 8 is a schematic view showing the manner of mounting of a surface-mounting type integrated circuit element on a printed circuit board;

Fig. 9 is a fragmentary schematic side elevation view showing an essential part of another embodiment of a circuit element mounting apparatus according to the present invention; and

Fig. 10 is a fragmentary schematic side elevation view showing an essential part of a further embodiment of a circuit element mounting apparatus according to the present invention.

DETAILED DESCRIPTION OF THE PREFERRED EMBODIMENTS

Now, a circuit element mounting method according to the present invention and an apparatus therefor will be described hereinafter with reference to the accompanying drawings.

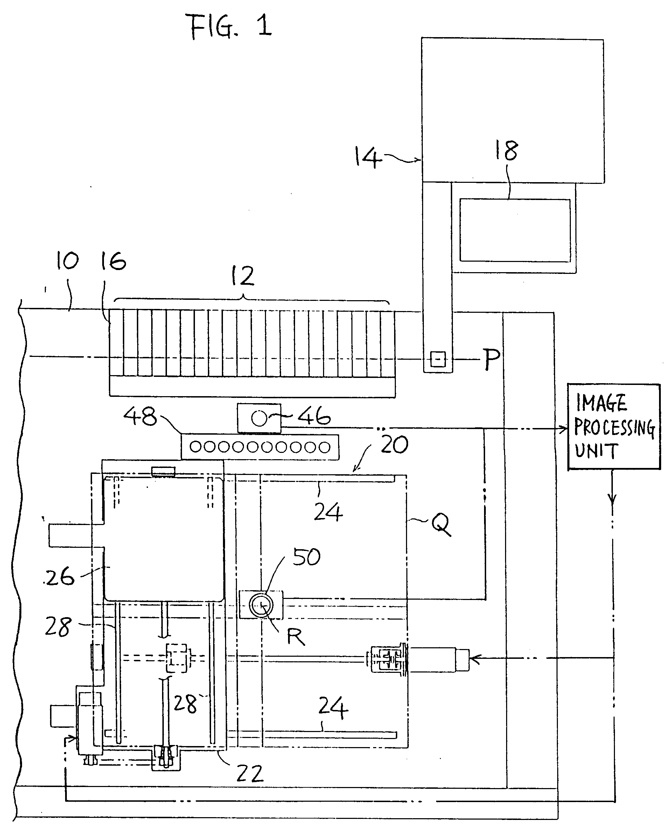

Figs. 1 to 3 illustrate an embodiment of a circuit element mounting apparatus according to the present invention, which is adapted to mount a chip-type circuit element (hereinafter referred to as "chip"), a surface-mounting type integrated circuit (IC) element and the like on a printed circuit board. A circuit element mounting apparatus of the illustrated embodiment includes a base 10, which has a first circuit element feed section 12 for feeding various kinds of chip-type circuit elements and a second circuit element feed section 14 for feeding surface mounting-type IC elements such as a QFP and the like arranged thereon. The word "chip" used herein may include a circuit element without any leads, as well as a circuit element having a small number of leads for surface mounting.

The first circuit element feed section 12 includes a plurality of feed units 16 which are arranged side by side for feeding chips. The feed units 16 include a tape feeder, a stick feeder and the like. The feed units 3 each function to feed chips one by one to each of chip pickup positions defined along dashed lines P in Fig. 1.

The second circuit element feed section 14 includes a tray sequencer 18 for extracting a plurality of surface-mounting type IC elements arranged on a tray one by one and functions to feed the IC elements one by one to a circuit element position on the dashed line P in Fig. 1.

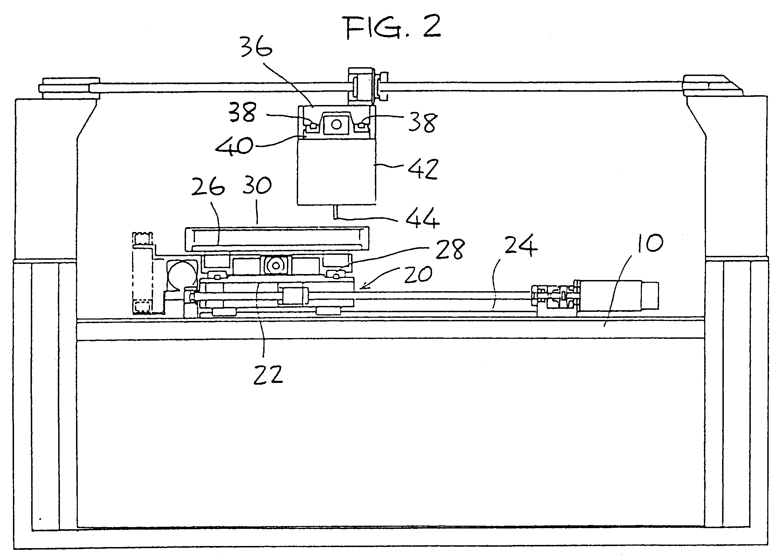

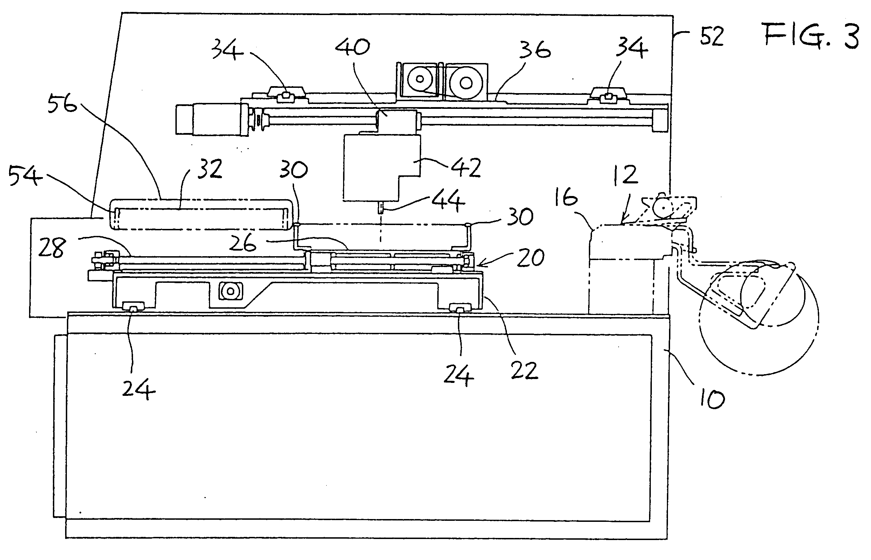

The apparatus of the illustrated embodiment also includes an X-Y table 20 fixedly arranged on the base 10. More particularly, the X-Y table 20 includes an X-direction slide table 22 provided so as to be slidable in an X direction on an X-direction rail 24 which may be mounted on the base 10 and a Y-direction slide table 26 disposed so as to be slidable in a Y direction on a Y-direction rail 28 fixed on the X-direction slide table 22. On the X-Y table 20 and more particularly on the Y-direction slide table 26, as shown in Figs. 2 and 3, is a board support rail 30 for slidably supporting a printed circuit board 32 thereon. The printed circuit board 32 is positioned with respect to the board support rail 30 along the rail 30 using a board positioning means (not shown). The printed circuit board 32 is moved within such a maximum moving range as indicated at a square Q of two-dot chain lines in Fig. 1.

Also, the apparatus of the illustrated embodiment, as shown in Figs. 2 and 3, further includes an X-direction rail 34 arranged above the base 10 and an X-direction slider 36 slidably supported on the X-direction rail 34, as well as a Y-direction rail 38 fixedly mounted on the X-direction slider 36 and a Y-direction slider 40 slidably supported on the Y-direction rail 38. On the so-arranged Y-direction slider 40 is supportedly mounted an X-Y mounting head 42, which includes a suction nozzle 44 adapted to hold a circuit element thereon by suction.

Between the first circuit element feed section 12 and the X-Y table 20, as shown in Fig. 1, are arranged a first image pickup means 46 such as a CCD camera or the like for taking an image of a chip held on the suction nozzle 44 by suction for recognizing the position and posture of the sucked chip through an image processing unit and a nozzle change station 48. The nozzle change station 48 serves to change the suction nozzle 44 mounted on the X-Y mounting head 42, so that the mounting head 42 may have the suction nozzle 44 of an optimal diameter depending upon a circuit element to be handled.

Also, on the base 10 is mounted a second image pickup means 50 such as a CCD camera or the like for taking an image of a surface-mounting type IC element such as a QFP or the like to recognize the position and posture of the sucked IC element through an image processing unit. The second image pickup means 50 is arranged at a predetermined position in an X-Y plane or horizontal plane. The predetermined position, as shown in Fig. 1, is defined so as to coincide with an IC element mounting position R resulting from the movement of the suction nozzle 44 having the IC element held thereon in the X-Y plane or be a position which permits the image pickup means 50 to take an image of the IC element suckedly held on the suction nozzle 44 moved to a location above the IC element mounting position R. For example, the IC element mounting position R may be desirably a center of the range of movement of the X-Y table 20, because it permits the amount of movement of the X-Y table 20 during the IC element mounting operation to be reduced.

The above-described components and/or mechanisms provided on the base 10, as shown in Figs. 2 and 3, are covered with an upper casing 52 provided with openings for the operation of the apparatus and the like as required.

The board support rail 30 of the X-Y table 20 is supplied with the printed circuit boards 32 from an external board carrying conveyor 54 through a board inlet 56. At this time, the X-Y table 20 is kept positioned a little to the left in Fig. 3. After the mounting operation, the printed circuit boards 32 each are then discharged through an board outlet to the external board carrying conveyor 54.

The manner of operation of the circuit element mounting apparatus of the illustrated embodiment constructed as described above will be described hereinafter with reference to Figs. 1 to 8.

The printed circuit boards 32 fed through the board carrying conveyor 54 each are supported on the board support rail 30 of the X-Y table 20 and located at a position predetermined with respect to the rail 30. Then, the X-Y table 20 is stopped at a fixed position nearest the first image pickup means 46.

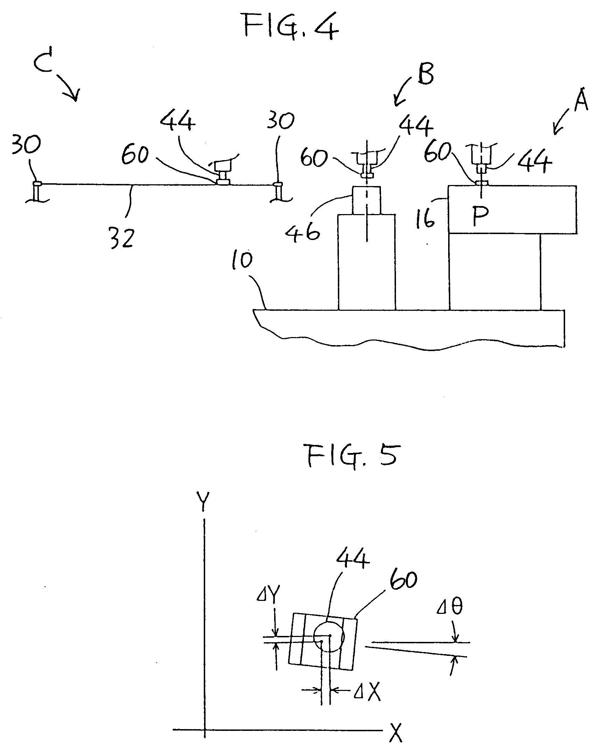

Then, the operation of mounting the chips fed from the first circuit element feed section 12 is executed by moving the suction nozzle 44 in the X-Y plane while keeping the X-Y table 20 stopped. More particularly, as generally indicated at an arrow A in Fig. 4, the suction nozzle 44 is moved to a location above the chip pickup position P of designated one of the feed units 16 of the first circuit element feed section 12 to hold a chip 60 thereon by suction, as indicated at the arrow A in Fig. 4. Then, the suction nozzle 44 is transferred to a location above the first image pickup means 46 while holding the chip 30 thereon, as generally indicated at an arrow B in Fig. 4.

Subsequently, the chip 60 is subject to image pickup processing through the first image pickup means 46 while being kept at the state indicated at the arrow B in Fig. 4, resulting in the position and posture (rotation) of the chip 60 being recognized through the image processing unit. More specifically, the image processing unit subjects an image signal generated from the first image pickup means 46 to image processing, so that the positional deviation between the center of the suction nozzle 44 and the center of the chip 60 and the deviation of the posture are determined as shown in Fig. 5, wherein $\Delta X$, $\Delta Y$, and $\Delta \theta$ indicate the amount of deviation in the X direction (positional deviation), the amount of deviation in the Y direction (positional deviation) and the amount of deviation in the rotational direction (deviation of posture), respectively. Then, as generally indicated at an arrow C in Fig. 4, a coordinate of the chip mounting position originally designated on the printed circuit board 32 supported at the fixed position on the board support rail 30 on the X-Y table 20 stopped at the predetermined position is corrected in view of the so-determined diviations $\Delta X$, $\Delta Y$ and $\Delta \theta$ and additional deviations in the directions of X and Y, caused by the rotation of the suction nozzle 44 for correcting $\Delta \theta$, and then the operation of mounting the chip 60 on the printed circuit board 32 is carried out.

The chip mounting operation per se may be carried out in substantially the same manner as the prior art. In the operation, it would be considered that the chip 60 is misregistered with respect to the suction nozzle 44 during the movement of the suction nozzle 44 in the X-Y plane. However, such misregistration can be disregarded or does not adversely affect the mounting operation, because electrodes of the chip 60 each have a relatively large width and the interval between the electrodes is defined to be relatively large.

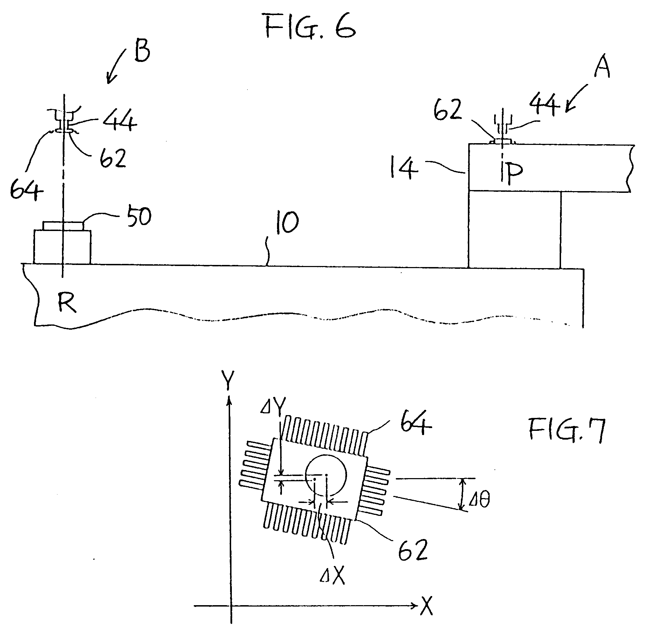

Following the mounting of the chip 60 on the printed circuit board 32, mounting of a surface-mounting type IC element such as a QFP or the like on the printed circuit board 32 is executed in such a manner as shown in Fig. 6. More particularly, the suction nozzle 44 is moved to the circuit element pick-up position P of the second circuit element feed section 14 to hold a surface-mounting type IC element 62 thereon by suction as generally indicated at an arrow A in Fig. 6. Then, the suction nozzle 44 is moved to a location above the IC element mounting position R defined above the second image pickup means 50 as indicated at an arrow B in Fig. 6 and concurrently the suction nozzle 44 rotates the IC element 62 to align it with a predetermined posture angle $\theta$ at which the IC element is mounted on the printed circuit board 32. Thereafter, the suction nozzle 44 is not moved in the X-Y directions. During the operation, the X-Y table 20 is located at a location which effectively prevents the printed circuit board 32 from obstructing the pickup of an image of the surface-mounting type IC element 62 through the second image pickup means.

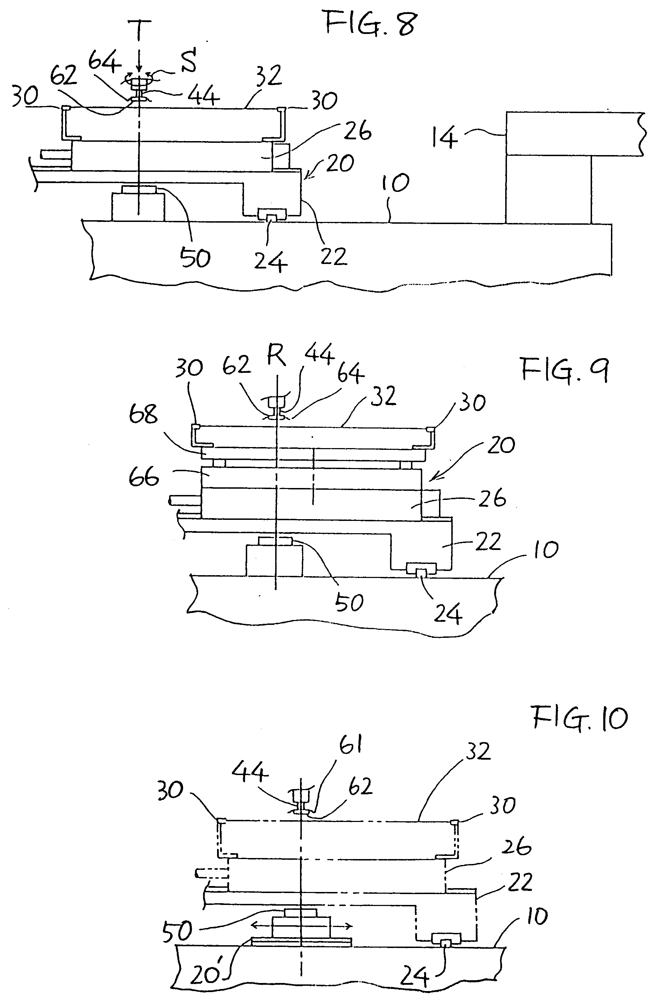

Then, an image of the IC element 62 is taken through the second image pickup means 50 while keeping the state indicated at the arrow B in Fig. 6, so that the position and posture (rotation) of the IC element 62 held on the suction nozzle 44 is recognized together with leads 64 of the IC element 62 through the image processing unit. More particularly, an image signal generated from the second image pickup means 50 due to the image pickup by the means 50 is subject to image processing through the image processing unit to determine the positional deviation between the center of the suction nozzle 44 and the center of the IC element 62 and the deviation of posture of the IC element as shown in Fig. 7, wherein $\Delta X$, $\Delta Y$ and $\Delta \theta$ indicate the amount of deviation in the X direction (positional deviation), the amount of deviation in the Y direction (positional deviation), and the amount of deviation in the rotational direction (deviation of posture), respectively. Then, the X-Y table 20 is moved by an amount obtained by correcting the amount of movement of the X-Y table 20 determined on the basis of a coordinate of the IC element mounting position designated on the printed circuit board 32 in view of the so-obtain deviations $\Delta X$, $\Delta Y$ and additional deviations in the directions of X and Y, caused by the rotation of the suction nozzle 44 for correcting $\Delta \theta$ shown below, and also, as indicated at an arrow S in Fig. 8, the correction of rotation of the suction nozzle 44 is carried out in view of the amount of deviation of the posture $\Delta \theta$, resulting in accomplishing accurate alignment between the IC element mounting position designated on the printed circuit board 32 and the position of the IC element 62 as shown in Fig. 8. Then, the suction nozzle 44 is lowered as indicated at an arrow T in Fig. 8 for mounting the IC element 62 on the printed circuit board 32. After the mounting, the suction nozzle 44 is upwardly returned to the original position in readiness for the next mounting operation, whereas the printed circuit board 32 on which the circuit elements have been mounted as described above is discharged from the X-Y table 20 through the board outlet to the board carrying conveyor 54.

The circuit element mounting positions designated on the printed circuit board 32 each have a suitable adhesive means such as creamy solder, conductive adhesive, temporary adhesive or the like previously deposited thereon by printing.

In the embodiment described above, after the surface-mounting type IC element 62 is recognized through the second image pickup means 50, the suction nozzle 44 merely carries out a function of vertically moving and a function of rotating by a micro angle for correction, so that the positional deviation of the IC element 62 after the operation for recognizing the position and posture of the element 62 may be substantially eliminated, resulting in the IC element mounting operation being accomplished with high accuracy.

Fig. 9 shows a second embodiment of a circuit element mounting apparatus according to the present invention. An apparatus of the illustrated embodiment includes an X-Y table 20 adapted to carry out both a function of rotating for correction and a function of vertically moving. More particularly, the X-Y table 20 includes a Y-direction slide table 26, a turntable 66 mounted on the slide table 26 and a lift table 68 mounted on the turntable 66. Thus, a board support rail 30 for supporting a printed circuit board 32 thereon and a means for positioning the printed circuit board 32 are arranged on the lift table 68. The remaining part of the embodiment shown in Fig. 9 may be constructed substantially in the same manner as the embodiment described above with reference to Figs. 1 to 3.

In the second embodiment of Fig. 9 described above, image processing of an image signal generated from a second image pickup means 50 which has taken an image of a surface-mounting type IC element 62 held on a suction nozzle 44 by suction moved to an IC element mounting position R causes the positional deviation between the center of the suction nozzle 44 and the center of the IC element 62 and the deviation of posture of the IC element 40 to be determined. The amount of deviation in the X direction (positional deviation), the amount of deviation in the Y direction (positional deviation) and the amount of deviation in the rotational direction (deviation of posture) may be indicated at $\Delta$ X, $\Delta$ Y, and $\Delta\,\theta$ , respectively, as in the embodiment described above. Then, the X-Y table 20 is moved by an amount obtained by correcting the amount of movement of the X-Y table 20 determined on the basis of a coordinate of the IC element mounting position designated on the printed circuit board 32 in view of the so-obtained deviations $\Delta$ X, $\Delta$ Y and additional deviations in the directions of X and Y, caused by the rotation of the turntable 66 for correcting $\Delta\,\theta$ shown below, and also, the correction of rotation of the turntable 66 is carried out on the basis of the current posture of the element at which the board support rail 30 is orientated in parallel to an X direction and in view of the amount of deviation of the posture $\Delta\,\theta$, resulting in accomplishing accurate alignment between the IC element mounting position designated on the printed circuit board 32 and the position of the IC element 62. Then, the lift table 68 is raised, so that the mounting operation is executed. After the mounting operation, the lift table 68 is lowered and the turntable 66 is returned to the original position at which the board support rail 30 is caused to be parallel with the X direction.

In the second embodiment shown in Fig. 9, the suction nozzle 44 is kept stationary in readiness for the next mounting operation after it reaches the IC element mounting position R within the X-Y plane, so that the positional deviation of the surface-mounting type IC element 62 after it is recognized through the second image pickup means 50 is completely prevented.

The above-described second embodiment may be so constructed that the lift table 68 is eliminated from the X-Y table 20 and substitutionally the board support rail 30 and positioning means are arranged on the turntable 66. Such construction permits only the suction nozzle 20 to carry out the vertical movement after the IC element 62 is recognized through the second image pickup means 50.

In each of the embodiments described above, the second image pickup means 50 used has a significantly wide visual field and is fixed on the base 10. However, when the second image pickup means 50 used has a narrow visual field, it is required to move it.

Fig. 10 shows a further embodiment of a circuit element mounting apparatus according to the present invention, which is adapted to incorporate a second image pickup means of a narrow visual field therein. For this purpose, an apparatus of the illustrated embodiment includes a base 10, a small-sized X-Y table 20' which is mounted at the bottom thereof on the base 10 and adapted to be moved within a predetermined range, and a second image pickup means 50 fixed on the X-Y table 20', resulting in the second image pickup means being movable. In such construction of the illustrated embodiment, the movement of the second image pickup means 50 permits the image of a required part of a surface-mounting type IC element 62 to be positively taken, to thereby determine the positional deviation between the center of the suction nozzle 44 and the center of the IC element 62 and the deviation of posture of the IC element in a manner similar to Fig. 7.

The remaining part of the embodiment shown in Fig. 10 may be constructed in substantially the same manner as the first embodiment described above.

In the embodiment shown in Figs. 1 to 3, the X-Y table 20 is kept free when the surface-mounting type IC element 62 is recognized through the second image pickup means 50; therefore, the embodiment may be constructed in such a manner that the second image pickup means 50 is mounted on the periphery of the X-Y table 20. In this instance, it is preferable that the range of movement of the X-Y table 20 is increased to a degree sufficient to permit the second image pickup means 50 to be positioned in proximity to the IC element mounting position R of the suction nozzle 44.

As can be seen from the foregoing, the present invention is so constructed that the position and posture of the circuit element held on the suction nozzle moved to the circuit element mounting position in the X-Y plane are recognized through the image processing unit including the image pickup means and then the suction nozzle is kept stationary. Such construction of the present invention effectively prevents the positional and rotational deviation of the circuit element with respect to the suction nozzle, to thereby ensure the circuit element mounting operation with high accuracy. Such an advantage of the present invention can be remarkably exhibited when the mounting of a surface-mounting type IC element having the increased number of leads such as a QFP or the like is carried out.

While preferred embodiments of the invention have been described with a certain degree of particularity with reference to the drawings, obvious modifications and variations are possible in light of the above teachings. It is therefore to be understood that within the scope of the appended claims, the invention may be practiced otherwise than as specifically described.

## Claims

1. A circuit element mounting method which is adapted to hold each of circuit elements (62) fed from a circuit element feed section (14) on a suction nozzle (44) by suction to mount it on a position designated on a printed circuit board (32) supported on an X-Y table (20), the improvement which comprising the steps of:

    moving the suction nozzle (44) to a location above a circuit element mounting position (R) in an X-Y plane while holding the circuit element (62) on the suction nozzle (44) by suction;

    recognizing the position and posture of the circuit element (62) held on the suction nozzle (44) by means of an image processing unit including an image pickup means (50); and

    moving the X-Y table (20) depending upon results of said recognizing step to carry out mounting of the circuit element (62) on the designated position on the printed circuit board (32).

2. A circuit element mounting method as defined in Claim 1, wherein the suction nozzle (44) merely rotates for correction and vertically moves after the circuit element (62) is recognized through the image processing unit.

3. A circuit element mounting method as defined in Claim 1, wherein the X-Y table (20) has a function of rotating for correction, so that the suction nozzle (44) merely vertically moves after the circuit element (62) is recognized through the image processing unit.

4. A circuit element mounting method as defined in Claim 1, wherein the X-Y table (20) exhibits both a function of vertically moving and a function of rotating for correction, so that the suction nozzle (44) is kept stationary after the circuit element (62) is recognized through the image processing unit.

5. A circuit element mounting apparatus for holding each of circuit elements (62) fed from a circuit element feed section (14) on a suction nozzle (44) by suction to mount it on a position designated on a printed circuit board (32) supported on an X-Y table (20), the improvement which comprising:

    an image pickup means (50) arranged at a position which permits an image of the circuit element (62) held on said suction nozzle (44) moved to a location above a circuit element mounting position (R) in an X-Y plane to be taken a recognize the position and posture of the circuit element (62);

    said X-Y table (20) having a range of movement sufficient to permit an operation of moving the printed circuit board (32) so as to prevent it from obstructing image pickup of the circuit element (62) through said image pickup means (50) and an operation of coinciding a coordinate of the designated position on the printed circuit board (32) in said X-Y plane with said circuit element mounting position (R) to be carried out.

6. A circuit element mounting apparatus as defined in Claim 5, wherein said image pickup means (50) is movable within a predetermined range.

7. A circuit element mounting apparatus as defined in Claim 5, wherein said suction nozzle (44) merely rotates for correction and vertically moves after the circuit element (62) is recognized through said image pickup means (50).

8. A circuit element mounting apparatus as defined in Claim 5, wherein said X-Y table (20) has a function of rotating for correction, so that said suction nozzle (44) merely vertically moves after the circuit element (62) is recognized through said image pickup means (50).

9. A circuit element mounting apparatus as defined in Claim 5, wherein said X-Y table (20) exhibits both a function of vertically moving and a function of rotating for correction, so that said suction nozzle (44) is kept stationary after the circuit element (62) is recognized through said image pickup means (50).

10. A circuit element mounting apparatus as defined in Claim 5, wherein said image pickup means (50) is mounted on said X-Y table (20).

11. A circuit element mounting apparatus as defined in Claim 10, wherein said range of movement of said X-Y table (20) is defined so as to permit said image pickup means (50) to be positioned in proximity to said circuit element mounting position (R).

# FIG. 1

FIG. 2

FIG. 3

EP 0 471 272 A1

FIG. 4

FIG. 5

FIG. 6

FIG. 7

FIG. 8

FIG. 9

FIG. 10

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 355 836 (TDK CORPORATION) <br> * page 6, line 45 - page 7, line 45; figures 2-4 * <br> ----- | 1,3,5,8 | H05K13/08 <br> H05K13/04 |

TECHNICAL FIELDS SEARCHED (Int. Cl.5)

H05K
H01L

The present search report has been drawn up for all claims

| Place of search | Date of completion of the search | Examiner |
|---|---|---|
| THE HAGUE | 27 NOVEMBER 1991 | BOLDER G.J.A. |

EPO FORM 1503 03.82 (P0401)